(19) Europäisches Patentamt
European Patent Office
Office européen des brevets

(11) **EP 2 469 977 A1**

(12) **EUROPEAN PATENT APPLICATION**
published in accordance with Art. 153(4) EPC

(43) Date of publication:
**27.06.2012 Bulletin 2012/26**

(51) Int Cl.:
*H05B 33/02* (2006.01)   *H01L 51/50* (2006.01)
*H05B 33/10* (2006.01)

(21) Application number: **10809901.1**

(22) Date of filing: **11.08.2010**

(86) International application number:
**PCT/JP2010/063646**

(87) International publication number:
**WO 2011/021556 (24.02.2011 Gazette 2011/08)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **20.08.2009 JP 2009190827**

(71) Applicants:
• **Sumitomo Chemical Company, Limited Tokyo 104-8260 (JP)**
• **Agency for Science, Technology and Research Singapore 138632 (SG)**
(72) Inventors:
• **YAMAMOTO Kyoko Tsukuba-shi Ibaraki 305-0045 (JP)**
• **LOW Hong Yee Singapore 117602 (SG)**
• **ZHANG Feng Xiang Singapore 117602 (SG)**
• **WANG Benzhong Singapore 117602 (SG)**

(74) Representative: **Jackson, Martin Peter J A Kemp 14 South Square Gray's Inn London WC1R 5JJ (GB)**

(54) **MANUFACTURING METHOD FOR SUBSTRATE WITH ELECTRODE ATTACHED**

(57)   A process for producing a substrate with electrode for an organic electroluminescent device comprising a low-refractive index layer, a functional layer, and a transparent electrode that are laminated in this order, the substrate being for an organic electroluminescent device wherein the refractive index n1 of the electrode, the refractive index n2 of the functional layer, and the refractive index n3 of the low-refractive index layer satisfy the following formula (1):

$$\begin{cases} 0.\ 3 \geqq (n\ 1 - n\ 2) \geqq 0 \\ n\ 1 \geqq n\ 2 > n\ 3 \end{cases} \quad \dots (1)$$

the process comprising the step of forming the low-refractive index layer by forming raised and depressed portions on the surface of the low-refractive index layer by means of imprinting that uses a mold wherein multiple particles having an average particle size of 1.0 $\mu$m to 200 $\mu$m are laid on the surface of the base substrate of the mold, the step of forming the functional layer by applying a coating solution containing a material that will become the functional layer onto the surface of the low-refractive index layer wherein the raised and depressed portions have been formed and curing the coating, and the step of forming the electrode on the functional layer.

# FIG. 1

**Description**

[TECHNICAL FIELD]

The present invention relates to a process for producing a substrate with electrode for an organic electroluminescent device (hereinafter, sometimes referred to as an organic EL device); and an organic EL device, a lighting device, and display device comprising the substrate with electrode.

[BACKGROUND ART]

Organic EL devices using organic substances as light-emitting materials are drawing attention as light-emitting device. An organic EL device consists of a pair of electrodes and an emitting layer placed between the electrodes. When a voltage is applied to an organic EL device, electrons are injected from the cathode and at the same time holes are injected from the anode; and these electrons and holes bind together at the emitting layer, thereby emitting light.

The light emitted from the emitting layer goes through the electrode to the outside, so a transparent electrode capable of transmitting light is used as one of a pair of electrodes. This transparent electrode generally uses a thin film made, for example, of indium tin oxide (ITO). An organic EL device is formed on a substrate with electrode where, for example, an ITO thin film is formed on the surface of the electrode, allowing the light emitted from the emitting layer to go through the ITO thin film and the substrate to the outside.

A comparison of the refractive indices of the substrate and the transparent electrode shows that the transparent electrode generally has a higher refractive index. For example, glass substrates have a refractive index of about 1.5, whereas ITO thin films have a refractive index of about 2.0. The relationship of the refractive index between the transparent electrode and the substrate causes the total reflection of the light emitted from the emitting layer to occur at the interface between the transparent electrode and the substrate. Most of the light emitted from the emitting layer is trapped in an device because of reflection due to this difference in refractive index and the like and does not go to the outside, resulting in ineffective use of the light.

For this reason, in order to increase the light extraction efficiency, substrates for organic EL devices where a structure reducing reflection and the like is formed have been proposed. For example, an organic EL device that uses a substrate in which a plurality of microlenses are formed has been disclosed (e.g., see Patent Document 1).

[PRIOR ART DOCUMENT]

[Patent Document]

[Patent Document 1] JP-A-2003-86353

[SUMMARY OF THE INVENTION]

[Problem to be Solved by the Invention]

In conventional art, structures that will become microlenses are formed on the surface of a photosensitive resin by photolithography, and microstructural microlenses having the desired shape and arrangement are difficult to form. For example, it is very difficult to prepare a plurality of microlenses that are each approximately semispherical at a high filling factor, making it impossible to easily form microlenses as optically designed that allow for a high extraction efficiency. This is a problem of the convention art.

Therefore, an object of the present invention is to provide a process for producing a substrate with electrode for an organic EL device where the process makes it possible to easily prepare a structure that allows for a high light extraction efficiency.

[Means for Solving the Problem]

The present invention relates to a process for producing a substrate with electrode comprising a low-refractive index layer, a functional layer, and a transparent electrode that are laminated in this order, the substrate being for an organic electroluminescent device wherein the refractive index n1 of the electrode, the refractive index n2 of the functional layer, and the refractive index n3 of the low-refractive index layer satisfy the following formula (1):
$$\begin{cases} 0.3 \geqq (n\,1 - n\,2) \geqq 0 \\ n\,1 \geqq n\,2 > n\,3 \end{cases} \quad \dots (1)$$

the process comprising

the step of forming the low-refractive index layer by forming raised and depressed portions (an uneven part) on the surface of the low-refractive index layer by means of imprinting that uses a mold wherein multiple particles having an average particle size of 1.0 $\mu$m to 200 $\mu$m are laid on the surface of the base substrate of the mold,
the step of forming the functional layer by applying a coating solution containing a material that will become the functional layer onto the surface of the low-refractive index layer wherein the raised and depressed portions (the uneven part) have been formed and curing the coating, and
the step of forming the electrode on the functional layer.

In addition, the present invention relates to a process for producing a substrate with electrode for an organic electroluminescent device wherein the multiple particles are each approximately spherical and laid on the surface of the base substrate in a nearly close-packed arrangement.

In addition, the present invention relates to an organic electroluminescent device comprising a substrate with electrode prepared by the production process.

In addition, the present invention relates to a lighting device or a display device comprising the organic electroluminescent device.

[Advantage of the Invention]

According to the present invention, a substrate with electrode for an organic electroluminescent device comprising a structure that allows for a high light extraction efficiency can be easily prepared.

[BRIEF DESCRIPTION OF THE DRAWINGS]

Fig. 1 is a schematic view of an organic EL device 8 comprising a substrate with electrode 1 for an organic electroluminescent device.
Fig. 2 is a schematic view of a mold; Fig. 2(1) is a cross-sectional view enlarging part of the mold and Fig. 2(2) is a plan view of part of a mold where a grid frame is formed.
Fig. 3 is a schematic view of the steps of producing a substrate with electrode.
Fig. 4 is emission profiles of PL emission intensity in Example 1 and Comparative Example 1.

[MODE FOR CARRYING OUT THE INVENTION]

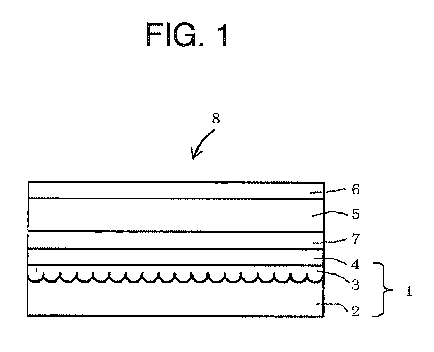

The process for producing a substrate with electrode for an organic EL device according to the present invention and the configuration thereof will be described below in detail by referring to Fig. 1. Fig. 1 is a schematic view of an organic EL device 8 comprising a substrate with electrode 1 for an organic EL device that is an embodiment obtained by the production process according to the invention.

The organic EL device 8 comprises a pair of electrodes and an emitting layer arranged between the electrodes. In the present embodiment, a transparent electrode (hereinafter referred to as a first electrode 4) mounted on the substrate with electrode 1 functions as one of the pair of the electrodes. In addition, hereinafter, the other of the pair of the electrodes is referred to as a second electrode 6.

The organic EL device 8 comprises at least one emitting layer 5 between the first electrode 4 and the second electrode 6, and may comprises a plurality of emitting layers and may also comprises a specified layer different from the emitting layer between the first electrode 4 and the second electrode 6 in consideration of the required characteristics, ease of steps, and the like. The organic EL device 8 of the present embodiment shown in Fig. 1 comprises a hole injection layer 7 as the specified layer different from the emitting layer and comprises the substrate with electrode 1, the hole injection layer 7, the emitting layer 5, and the second electrode 6 that are laminated in this order.

The first electrode 4 of the present embodiment functions as an anode, and the second electrode 6 functions as a cathode. This second electrode 6 preferably comprises a light-reflecting material. In addition, the low-refractive index layer 2 and the functional layer 3 comprise a transparent material. In other words, the substrate with electrode 1 is transparent. For these reasons, the light emitted from the emitting layer 5 toward the first electrode 4 goes through the substrate with electrode 1 containing the first electrode 4 to the outside. In addition, the light emitted from the emitting layer 5 toward the second electrode 6 is reflected on the second electrode 6 and goes through the substrate with electrode 1 to the outside. In other words, the organic EL device 8 of the present embodiment is a bottom-emitting device where the light goes out of the substrate with electrode 1. However, as a variant, the organic EL device 8 may be a bottom-emitting organic EL device using the first electrode a cathode and the second electrode as an anode, and may also be a double-sided light-emitting organic EL device, using a transparent electrode as the second electrode, that also emits light from the second electrode side.

The substrate with electrode 1 comprises at least the low-refractive index layer 2, the functional layer 3, and the first electrode 4 which is transparent that are laminated in this order. In addition, when the refractive index of the first electrode 4 is n1, the refractive index of the functional layer 3 is n2, and the refractive index of the low-refractive index layer 2 is n3, the refractive indices of the materials satisfy the following formula (1). However, for example, a thin insulating layer or a thin barrier layer may be provided between the functional layer 3 and the first electrode 4.

$$\begin{cases} 0.3 \geqq (n1 - n2) \geqq 0 \\ n1 \geqq n2 > n3 \end{cases} \quad \ldots (1)$$

The interface between the low-refractive index layer 2 and the functional layer 3 is formed unevenly, and this uneven interface functions as a plurality of microlenses. In the present embodiment, a plurality of microlenses 0.4 $\mu$m to 100 $\mu$m high are formed at the interface between the low-refractive index layer 2 and the functional layer 3.

As shown in Expression (1), the difference in refractive index between the functional layer 3 and the first electrode 4 is small, making it possible to reduce total reflection at the interface between the functional layer 3 and the first electrode 4 and thus reduce the reflectance. This allows the light that is emitted from the emitting layer 5 and enters the first electrode 4 to be efficiently propagated into the functional layer 3. In addition, the total reflection at the interface between the functional layer 3 and the low-refractive index layer 2 can be reduced by forming an uneven interface between the functional layer 3 and the low-refractive index layer 2. This allows the light entering the functional layer 3 from the first electrode 4 to be efficiently propagated into the low-refractive index layer 2 which has a lower refractive index than the functional layer 3. Moreover, as shown in Expression (1), the substrate with electrode 1 has a layer structure where a layer closer to the outside world (air) has a lower refractive index, making it possible to provide a smaller difference in refractive index between the layer in contact with the air (the low-refractive index layer 2) and the air. This can reduce the total reflection at the surface of the organic EL device 8 from which light goes to the outside (outgoing surface) and thus reduce the reflectance. By doing so, an organic EL device 8 having a high light extraction efficiency can be realized.

1. Process for producing the substrate with electrode

The process for producing the substrate with electrode 1 of the present embodiment comprises the step of forming the low-refractive index layer by forming raised and depressed portions (uneven parts) on the surface of the low-refractive index layer by imprinting that uses, as a mold, a base substrate on the surface of which multiple particles having an average particle size of 1.0 $\mu$m to 200 $\mu$m are laid; the step of forming the functional layer by applying a coating solution containing a material which will become the functional layer to the surface of the low-refractive index layer on which the raised and depressed portions (uneven parts) have been formed and curing the coating; and the step of forming an electrode on the functional layer.

<Step of forming the low-refractive index layer>

In this step, the low-refractive index layer is formed by forming the low-refractive index material by forming raised and depressed portions (uneven parts) on the surface of the low-refractive index layer by imprinting that uses, as a mold, a base substrate on the surface of which multiple particles having an average particle size of 1.0 $\mu$m to 200 $\mu$m are laid. As used herein, average particle size refers to the average diameter of particles and means the average particle size (arithmetic mean diameter) calculated based on the volume-based particle size distribution measured with a laser diffraction/scattering particle size distribution analyzer. A laser diffraction/scattering particle size distribution analyzer refers to a measuring instrument to analyze particle size distribution based on the measurement results obtained by directing a laser beam toward particles and measuring the light intensity distribution of its diffracted light/scattered light. Particle size distribution analyzers using this principle are commercially available and can be used to measure average particle size.

The particle size of particles laid on the base substrate surface is 1.0 μm to 200 μm, and to effectively prevent light reflection at the interface between the low-refractive index layer 2 and the functional layer 3, preferably 1.6 μm to 160 μm and more preferably 2.0 μm to 100 μm. In addition, when a distribution of groups of particles is graphed with particle size on the horizontal axis and the abundance of groups of particles having various sizes on the vertical axis as well as the average particle size is d and the abundance of a group of particles having a size of d is A whereas the absolute value of the difference between the particle size of a group of particles at which the abundance becomes A/2 and d is defined as "particle size," the particle size distribution of particles used is preferably 0.6d to 11.4d and more preferably 0.8d to 1.2d.

The material for particles laid on the base substrate is not particularly limited, and preferably has excellent strength, heat resistance, light resistance, adhesion to the base substrate, and the like required for use as an imprint mold. Examples of the material include organic substances such as polystyrene, poly(methylmethacrylate) (PMMA), polyethylene, and polyethylene terephthalate and inorganic substances such as silica, titanium oxide, barium titanate, and alumina. In addition, when the low-refractive index layer for imprinting uses a photocurable monomer, a material for the particles is preferably transparent to ultraviolet light directed to photocure the photocurable monomer.

The shape of particles is appropriately defined depending on the optical design because it specifies the shape of the interface between the low-refractive index layer 2 and the functional layer 3. Examples of the shape of particles include approximately spherical shape and approximately ellipsoidal shape and further a shape where a protrusion is formed thereon and a shape where a hole is formed therein. To effectively prevent light reflection at the interface between the low-refractive index layer 2 and the functional layer 3, the shape of particles is preferably approximately spherical or approximately ellipsoidal and more preferably approximately spherical. However, the approximately spherical shape and approximately ellipsoidal shape include spherical shape and ellipsoidal shape, respectively.

The surface of particles may be smooth or uneven. In addition, particles may be heat-treated or chemically or physically surface-modified. For example, to disperse particles uniformly in a dispersion solvent, particles may be surface-treated with a silane coupling agent or the like.

Examples of a method of laying particles on the base substrate surface include a coating method. For example, particles can be laid on the base substrate surface by applying a liquid dispersion where the multiple particles are dispersed in a dispersion solvent onto the base substrate surface and removing the dispersion solvent.

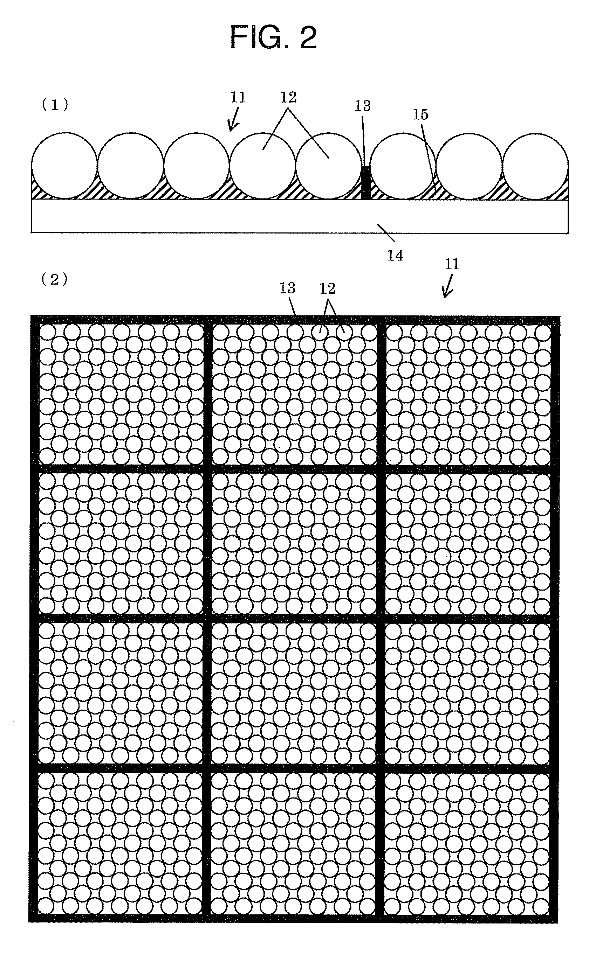

Fig. 2 is a schematic view of a mold. Fig. 2(1) is a cross-sectional view enlarging part of the mold and Fig. 2(2) is a plan view of part of the mold where a grid frame is formed.

In view of higher light extraction efficiency, preferably, multiple particles 12 are each approximately spherical and are laid on a base substrate 14 in a close-packed arrangement. As used herein, close-packing refers to laying particles on a base substrate as densely as possible without forming two or more layers (see Fig. 2(1)). Examples of a method of laying particles on the base substrate surface include the technique using self-organization described in Colloids and surfaces, 109(1996)363. However, particles are preferably laid all over the base substrate surface in a close-packed arrangement and may be laid in a close-packed arrangement over each of multiple small areas into which the whole area of the base substrate surface is divided. When a self-organization method is used, a special frame 13 may be provided on the base substrate surface to lay particles in a nearly close-packed arrangement uniformly over a wide area. For example, after the grid frame 13 cutting the base substrate surface into small square areas is provided on the surface of the base substrate 14, particles may be laid by self-organization in a nearly close-packed arrangement over each of the areas enclosed by the frame 13. The shape, material, width, and height of the frame 13 are not particularly limited, and a shape that allows for laying particles in a nearly close-packed arrangement is preferable. In addition, when particles are laid by application of a coating solution or the like, a material for the frame 13 is preferably a material having resistance to the coating solution. The frame 13 can be formed in a specified pattern, for example, with a photoresist by photolithography. Moreover, a material for the frame is preferably a material that is unsusceptible to the heat and light during imprinting when the base substrate is used as a mold. The width of the frame is preferably narrow to widen the area over which particles are laid. The height of the frame 13 is preferably half or less the average particle size of particles used when the base substrate is used as a mold.

The multiple particles laid on the base substrate surface need to be fixed onto the base substrate to use it as an imprint mold. To fix the particles onto the base substrate, an adhesive material 15 that sticks the particles onto the base substrate may be provided on the mold. The adhesive material 15 is arranged, for example, so that it fills the gap between the particles 12 and the base substrate 14. A material for the adhesive material 15 is not particularly limited and needs to have heat resistance, strength, light resistance, and the like required for use as an imprint mold 11. Examples of the material include silica formed by sol-gel method. In addition, to realize a mold comprising a plurality of approximately semispherical raised portions (uneven parts), the adhesive material 15 is preferably formed up to a position equal to or less than half the height (radius) of the particles 12 with the particles laid on the base substrate 14, in other words, the portions equal to or greater than half the height (radius) of the particles 12 preferably protrude from the adhesive material 15. Examples of a method of providing the adhesive material 15 in this arrangement include a method using capillary action. For example, when the multiple particles 12 are laid on the base substrate and then a liquid adhesive is injected, capillary action allows the adhesive to flow so that it fills the gap between the particles and the substrate. Curing the adhesive filling the gap allows for the formation of the adhesive material 15 up to a position equal to or less than half the height (radius) of the particles 12.

However, for example, if particles whose surface has undergone a specified treatment with a silane coupling agent or the like are used, such multiple particles can also be fixed onto the base substrate by laying the particles onto the base substrate followed by heat treatment or the like.

The mold shape can be transferred to the low-refractive index layer 2 by an imprinting method that uses, as a mold, a base substrate on which the particles are laid. As the imprinting method, a method suitable for the material used for the low-refractive index layer 2 is applicable and examples of the method include thermal imprinting and photoimprinting. Thermal imprinting allows for transferring the shape of a mold, for example, by pressing the mold against a thermoplastic resin in a heated state. In contrast, photoimprinting allows for transferring the shape of a mold, for example, by irradiating a layer made of a photocurable monomer with ultraviolet light, while the layer being pressed against the mold, to polymerize the photocurable monomer. This photoimprinting forms a plurality of depressed portions (uneven parts) 0.4 $\mu$m to 100 $\mu$m high on the low-refractive index layer 2. Especially, the use of a base substrate on which approximately spherical particles are laid as a mold allows a plurality of semispherical depressed portions (uneven parts) 0.4 $\mu$m to 100 $\mu$m high to be formed on the low-refractive index layer 2.

As the low-refractive index layer 2, a low-refractive index layer that has a high light transmittance in the visible region and stays unchanged during the step of fabricating an organic EL device is preferably used. In addition, because of its production process, the low-refractive index layer requires a material capable of transferring the surface shape of a mold by the imprinting method above. For example, plastic plates, or laminated plates where a plastic film and a silicon plate, glass, or the like are laminated are preferably used.

Examples of the low-refractive index layer 2 include polyolefin resins such as low-density or high-density polyethylene, ethylene-propylene copolymer, ethylene-butene copolymer, ethylene-hexene copolymer, ethylene-octene copolymer, ethylene-norbornene copolymer, ethylene-dimethanooctahydronaphthalene (DMON) copolymer, polypropylene, ethylene-vinyl acetate copolymer, ethylene-methyl methacrylate copolymer, and ionomer resin; polyester resins such as polyethylene terephthalate, polybutylene terephthalate, and polyethylene naphthalate; amide resins such as nylon-6, nylon-6,6, meta-xylenediamine-adipic acid condensed polymer, and polymethylmethacrylimide; acrylic resins such as polymethyl methacrylate; styrene-acrylonitrile resins such as polystyrene, styrene-acrylonitrile copolymer, styrene-acrylonitrile-butadiene copolymer, and polyacrylonitrile; hydrophobized cellulose resins such as cellulose triacetate and cellulose diacetate; halogen-containing resins such as polyvinyl chloride, polyvinylidene chloride, polyvinylidene fluoride, and polytetrafluoroethylene; hydrogen-bonding resins such as polyvinyl alcohol, ethylene-vinyl alcohol copolymer, and cellulose derivatives; and engineering plastic resins such as polycarbonate resin, polysulfone resin, polyether sulfone resin, polyetheretherketone resin, polyphenylene oxide resin, polymethylene oxide resin, polyarylate resin, and liquid crystal resin.

The low-refractive index layer 2 is required to have heat resistance during the step of preparing an organic EL device, so among the resins listed above, resins having a glass transition temperature Tg of 150°C or more are preferable, resins having a Tg of 180°C or more are more preferable, and resins having a Tg of 200°C or more are much more preferable.

The low-refractive index layer 2 may further contain a material or a layer which have high barrier properties that refer to low permeability to oxygen, water vapor, and the like. In this case, a layer having high barrier properties needs to be provided on the portions where no uneven shape is formed by imprinting. As such a member having high barrier properties, for example, an inorganic layer comprising inorganic substances such as a metal, a metal oxide, a metal nitride, a metal carbide, and a metal oxynitride, a laminate comprising the inorganic layer and an organic layer, or a layer comprising an inorganic-organic hybrid material is preferably used. As the inorganic layer, a thin-film inorganic layer that is stable in air is preferable, and examples of the inorganic layer include thin-film layers of silica, alumina, titania, indium oxide, tin oxide, titanium oxide, zinc oxide, indium tin oxide, aluminum nitride, silicon nitride, silicon carbide, silicon oxynitride, and a combination thereof. Among these, as the inorganic layer, a thin-film layer of aluminum nitride, silicon nitride, or silicon oxynitride is preferable, and a thin-film layer of silicon oxynitride is more preferable.

A material constituting the low-refractive index layer is appropriately selected from the examples listed, depending on the refractive indices of the functional layer 3 and the first electrode 4 as long as Expression (1) is satisfied. The refractive index of the low-refractive index layer when the low-refractive index layer comprises a plurality of materials is the refractive index of the low-refractive index layer treated as one layer of a material.

The refractive index n3 of the low-refractive index layer is determined by the members constituting the low-refractive index layer, and for example, n3 is 1.58 for polycarbonate and 1.49 for polyethylene terephthalate, 1.65 for polyether sulfone, and 1.50 for polyethylene naphthalate.

<Step of forming the functional layer>

In this step, the functional layer 3 is formed by applying a coating solution containing a material that will become the functional layer 3 onto the surface of the low-refractive index layer 2 on which the raised and depressed portions (uneven parts) are formed and curing the coating. When the coating solution is applied to the low-refractive index layer 2 that have a plurality of depressed portions (uneven parts) 0.4 $\mu$m to 100 $\mu$m high formed on its surface, the depressed portions on the low-refractive index layer 2 are filled with the coating solution, so curing the coating solution can easily provide the functional layer 3 on which a plurality of raised portions (uneven parts) 0.4 $\mu$m to 100 $\mu$m high are formed. In addition, the use of this coating method can form a flat surface of the functional layer 3 on the first electrode 4 side. The coating solution may be a solution or a dispersion. Moreover, an organic solvent, a surfactant, an adhesion enhancer, a cross-linking agent, a sensitizing agent, or a photosensitizing agent may further be added to the coating solution as needed. Examples of the coating solution include a composition where nanoparticles having a high refractive index are dispersed in a monomer thermoplastic resin containing a silicon inorganic polymer and an aromatic, a composition where nanoparticles having a high refractive index are dispersed in a photocurable monomer, and a composition where nanoparticles having a high refractive index are dispersed in a thermosetting monomer. The applied coating on the low-refractive index layer can be cured by a specified treatment such as light irradiation, heating, drying, or pressurization, and for example, the functional layer 3 can be formed by the sol-gel process.

As the functional layer 3, a functional layer that has a high light transmittance on the visible region and stays unchanged during the step of fabricating an organic EL device is preferably used. In addition, the functional layer 3 may contain a material having high barrier properties that refer to low permeability to oxygen, water vapor, and the like. The functional layer 3 comprises, for example, an inorganic polymer and an inorganic-organic hybrid material. The inorganic-organic hybrid material includes a compound where a hybrid of inorganic and organic substances at the molecular level is formed and a mixture where an inorganic substance is dispersed in an organic substance.

Examples of the inorganic substance include a metal, a metal oxide, a metal nitride, a metal carbide, and a metal oxynitride. Inorganic substances that are stable in air are preferable, and examples thereof include silica, alumina, titania, indium oxide, tin oxide, titanium oxide, zinc oxide, indium tin oxide, aluminum nitride, silicon nitride, silicon carbide, silicon oxynitride, and mixtures thereof. As the inorganic substance, aluminum nitride, silicon nitride, and silicon oxynitride are preferable and silicon oxynitride is more preferable.

A member constituting the functional layer 3 is appropriately selected from the examples listed above, depending on the refractive indices of the low-refractive index layer 2 and the first electrode 4 as long as Expression (1) is satisfied. The refractive index of the functional layer satisfies the relationships shown by Expression (1) and a smaller difference in the refractive index between the functional layer and the transparent electrode (first electrode 4) can reduce total reflection more, so the refractive index of the functional layer is preferably 1.75 or more. However, the refractive index of the functional layer 3 when the functional layer constitutes a plurality of materials is the refractive index of the functional layer 3 treated as one layer of a material.

The refractive index n2 of the functional layer 3 is determined by the materials constituting the functional layer 3, and for example, n2 is 1.75 to 2.0 for silicon inorganic polymers and 1.8 to 2.0 for mixtures where $TiO_2$ is dispersed in a polymer.

The unevenness of the surface of the functional layer 3 on the first electrode 4 side affects the flatness of the first electrode 4 laminated on the surface of the functional layer 3. When the flatness of the first electrode 4 is low and a protrusion or the like is formed on the surface, sometimes this protrusion causes darkspots. For example, the hole injection layer 7 and the emitting layer 5 are thin, so a protrusion may penetrate through these layers, causing an unexpected short circuit. For this reason, roughness Ra of the first electrode 4 is preferably small, and to form such a first electrode 4, roughness Ra of the surface of the functional layer 3 on the first electrode 4 side is preferably small. Specifically, Ra is preferably 100 nm or less, more preferably 50 nm or less, much more preferably 10 nm or less, and still more preferably 3 nm or less.

The arrangement of depressed portions (uneven parts) formed on the low-refractive index layer 2 depends on the arrangement of particles on the base substrate surface. In the present embodiment, approximately spherical particles can be laid on the base substrate in a nearly close-packed arrangement, so the depressed portions (uneven parts) formed on the low-refractive index layer 2 can be provided in a nearly close-packed arrangement. The provision of approximately semispherical depressed portions (uneven parts) in such an arrangement reduces light reflection greatly, making it possible to improve light extraction efficiency. Especially, the provision of approximately semispherical depressed portions (uneven parts) allows the interface between the low-refractive index layer 2 and the functional layer 3 to function as a microlens array and reduce light reflection greatly, making it possible to improve light extraction efficiency.

<Step of forming the electrode on the functional layer>

In the present embodiment, the first electrode 4 is formed on the functional layer 3. The first electrode 4 of the present embodiment is realized by a thin film that is transparent and conductive, and comprises, for example, a metal oxide film and a metal thin film. Specifically, a thin film of indium oxide, zinc oxide, tin oxide, indium tin oxide (ITO), indium zinc oxide (IZO), gold, platinum, silver, copper, or the like can be used as the first electrode 4, and thin films of ITO, IZO, tin oxide, and the like are preferable. In addition, as the first electrode 4, an organic transparent conductive film such as polyaniline or a derivative thereof or polythiophene or a derivative thereof may be used. The thickness of the first electrode 4 can be appropriately defined in consideration of optical transparency and conductivity, and is generally about 10 nm to 10 $\mu$m, preferably 20 nm to 1 $\mu$m, and more preferably 50 nm to 500 nm.

Examples of a method of depositing the first electrode include vacuum evaporation, sputtering, ion plating, and plating.

The refractive index n1 of the first electrode is determined by the materials constituting the first electrode, and for example, n1 is 2.0 for ITO, 1.9 to 2.0 for IZO, and about 1.7 for organic transparent conductive films of polythiophene, a derivative thereof, or the like.. A material constituting the first electrode is appropriately selected from the examples listed above, depending on the refractive indices of the low-refractive index layer 2 and the functional layer 3 as long as Expression (1) is satisfied.

The substrate with electrode 1 can be prepared through the production steps above. As mentioned earlier, a substrate with electrode for an organic EL device comprising a structure that allows for a high light extraction efficiency can easily be prepared by means of imprinting.

As a combination of the low-refractive index layer 2, the functional layer 3, and the first electrode 4 constituting the substrate with electrode 1 of the present embodiment described above, a low-refractive index layer comprising a laminate of a glass substrate and a plastic sheet, a functional layer comprising an inorganic polymer layer, and a first electrode comprising ITO are preferable, and a low-refractive index layer comprising a resin layer, a functional layer comprising an inorganic polymer layer, and a first electrode comprising ITO is more preferable.

2. Organic EL device

As mentioned earlier, the organic EL device 8 of the present embodiment comprises a substrate with electrode 1 and can be prepared by laminating a hole injection layer 7, an emitting layer 5, and a second electrode 6 sequentially on the substrate with electrode 1.

<Hole injection layer>

Examples of the hole injection material constituting the hole injection layer include phenylamines, starburst amines, phthalocyanines, oxides such as vanadium oxide, molybdenum oxide, ruthenium oxide, and aluminum oxide, amorphous carbon, polyaniline, and a polythiophene derivative.

The hole injection layer can be formed, for example, by applying a coating solution containing a material that will become the hole injection layer onto the first electrode 4. Examples of a method of applying the coating solution include spin coating, casting, microgravure coating, gravure coating, bar coating, roll coating, wire bar coating, dip coating, spray coating, screen printing, flexographic printing, offset printing, and ink jet printing.

<Emitting layer>

The emitting layer comprises an organic substance emitting fluorescence and/or phosphorescence, or the organic substance and a dopant. A dopant is added for an improvement in luminous efficiency, a change in emission wavelength, or the like. The organic substance used for the emitting layer may be a small molecular compound or a polymer compound, and when the emitting layer is formed by a coating method, the organic substance preferably contains a polymer compound in view of its solubility in a coating solution. Examples of a light-emitting material constituting the emitting layer are as follows.

Examples of a dye light-emitting material include a cyclopentamine derivative, a tetraphenylbutadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, an oxadiazole dimer, and a pyrazoline dimer.

Examples of a metal complex light-emitting material include a metal complex where the central metal is a rare earth metal such as terbium (Tb), eruopium (Eu), or dysprosium (Dy) or a aluminum (Al), zinc (Zn), beryllium (Be), iridium (Ir), platinum (Pt), or the like while the ligand is an oxadiazole, thiadiazole, phenylpyridine, phenylbenzoimidazole, quinoline, or other structure. Examples of the metal complex include a meal complex such as an iridium complex or a platinum complex where the emission of light results from a triplet excited state, a quinolinol aluminum complex, a benzoquinolinol beryllium complex, a benzoxazolyl zinc complex, a benzothiazole zinc complex, an azomethyl zinc complex, a porphyrin zinc complex, and a phenanthroline europium complex.

Examples of a polymer light-emitting material include a poly(p-phenylenevinylene) derivative, a polythiophene derivative, a poly(p-phenylene) derivative, a polysilane derivative, a polyacetylene derivative, a polyfluorene derivative, and a polyvinylcarbazole derivative, and polymers prepared by polymerizing the dye light-emitting materials or metal complex light-emitting materials above.

Examples of a blue light-emitting material among the above light-emitting materials include a distyrylarylene derivative, an oxadiazole derivative, and polymers thereof, a polyvinylcarbazole derivative, a poly(p-phenylene) derivative, and a polyfluorene derivative. Among these, a polyvinylcarbazole derivative, a poly(p-phenylene) derivative, a polyfluorene derivative, and the like that are all polymer materials are preferable.

In addition, examples of a green light-emitting material include a quinacridone derivative, a coumarin derivative, and polymers thereof, a poly(p-phenylenevinylene) derivative, and a polyfluorene derivative. Among these, a poly(p-phenylenevinylene) derivative, a polyfluorene derivative, and the like that are all polymer materials are preferable.

In addition, examples of a red light-emitting material include a coumarin derivative, a thiophene ring compound, and polymers thereof, a poly(p-phenylenevinylene) derivative, a polythiophene derivative, and a polyfluorene derivative. Among these, a poly(p-phenylenevinylene) derivative, a polythiophene derivative, a polyfluorene derivative, and the like that are all polymer materials are preferable.

In addition, a white-light emitting material may be a polymer incorporating the blue, green, and red materials above or a polymer blend of materials in these colors. Moreover, it may be a laminate of materials in these colors.

Examples of the dopant material include a perylene derivative, a coumarin derivative, a rubrene derivative, a quinacridone derivative, a squalium derivative, a porphyrin derivative, a styryl dye, a tetracene derivative, a pyrazolone derivative, decacyclene, and phenoxazone. However, the thickness of the emitting layer is usually about 2 nm to 2000 nm.

Examples of a method of forming a film of an emitting layer containing an organic substance include a method of applying a coating solution containing a light-emitting material onto the hole injection layer 7, vacuum evaporation, and transfer printing. The solvent for a coating solution containing a light-emitting material needs only to be a liquid that dissolves the light-emitting material, and examples of the solvent include chlorine solvents such as chloroform, methylene chloride, and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate, and ethyl cellosolve acetate.

Examples of a method of applying a coating solution containing a light-emitting material include coating methods such as spin coating, casting, microgravure coating, gravure coating, bar coating, roll coating, wire bar coating, dip coating, slit coating, capillary coating, spray coating, and nozzle coating, gravure printing, screen printing, flexographic printing, offset printing, reverse printing, and ink jet printing. Coating methods such as gravure printing, screen printing, flexographic printing, offset printing, reverse printing, and ink jet printing are preferable because of their easy pattern formation and multicolor coating. In addition, vacuum evaporation can be used for sublimable small molecular compounds. Moreover, an emitting layer can be formed only in a desired area by a method such as laser transfer or thermal transfer.

<Second electrode>

In the present embodiment, the second electrode 6 is provided as a cathode. As a material for the second electrode, a material having a small work function that allows for easy electron injection into the emitting layer is preferable and a material having high conductivity is preferable. Specifically, metals such as alkali metals, alkaline earth metals, transition metals, and metals of group III-B can be used. More specifically, metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; or alloys of two or more of the above metals; or alloys of one or more of the above metals and one or more of gold, silver, platinum, copper, manganese, titanium, cobalt, nickel, tungsten, and tin; graphite or graphite intercalation compounds, or the like can be used. Examples of such alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. If emitting light is extracted from the second electrode as well, the second electrode needs to be transparent, and such a transparent second electrode comprises a laminate of a thin film made of the above material and a thin film made of a conductive metal oxide, a conductive organic substance, or the like.

As described above, the use of imprinting makes it possible to easily produce a structure reducing light reflection between the low-refractive index layer 2 and the functional layer 3, allowing easy preparation of an organic EL device having a high light extraction efficiency. Especially, an uneven interface can easily be produced in a close-packed arrangement between the low-refractive index layer 2 and the functional layer 3 in a close-packed arrangement by using, as a mold, a base substrate on the surface of which particles are laid in a close-packed arrangement.

In the organic EL device 8 of the present embodiment, the hole injection layer 7 and the emitting layer 5 are arranged between the first electrode 4 and the second electrode 6, but the configuration of the organic EL device 8 is not limited to the configuration shown in Fig. 1. An example of the configuration of an device between the first electrode and the second electrode of the organic EL device will be described below. However, the first electrode may be an anode or a cathode as long as it is transparent, so in the description below, the example of device configuration is described without specifying the polarity of the first electrode and the second electrode. In addition, if the low-refractive index layer 2 in film form is formed from a resin or the like, the low-refractive index layer 2 may be provided on a substrate made of glass or the like.

As mentioned earlier, at least one emitting layer needs only to be provided between the anode and the cathode, and a plurality of emitting layers, and/or one or more specified layers different from the emitting layer may be provided between the anode and the cathode.

Examples of a layer provided between the cathode and the emitting layer include an electron injection layer, an electron transport layer, and a hole blocking layer. If both an electron injection layer and an electron transport layer are provided between the cathode and the emitting layer, the layer located closer to the cathode is referred to as an electron injection layer, whereas the layer located closer to the emitting layer is referred to as an electron transport layer.

The electron injection layer is a layer that has the function of improving the efficiency with which electrons are injected from the cathode. The electron transport layer is a layer that has the function of improving the electron injection from the cathode or the electron injection layer, or the electron transport layer closer to the cathode. The hole blocking layer is a layer that has the function of blocking hole transport. However, sometimes the electron injection layer or the electron transport layer also functions as the hole blocking layer.

Examples of a layer provided between the anode and the emitting layer include a hole injection layer, a hole transport layer, and an electron blocking layer. If both a hole injection layer and a hole transport layer are provided between the anode and the emitting layer, the layer located closer to the anode is referred to as a hole injection layer, whereas the layer located closer to the emitting layer is referred to as a hole transport layer.

The hole injection layer is a layer that has the function of improving the efficiency with which holes are injected from the anode. The hole transport layer is a layer that has the function of improving the hole injection from the anode or the hole injection layer, or the hole transport layer closer to the anode. The electron blocking layer is a layer that has the function of blocking electron transport. Sometimes, the hole injection layer or the hole transport layer also functions as the electron blocking layer.

However, sometimes the electron injection layer and the hole injection layer are collectively referred to as the charge injection layers, whereas sometimes the electron transport layer and the hole transport layer are collectively referred to as the charge transport layers.

Examples of a possible layer configuration of the organic EL device of the present embodiment are listed below:

a) Anode/emitting layer/cathode
b) Anode/hole injection layer/emitting layer/cathode
c) Anode/hole injection layer/emitting layer/electron injection layer/cathode
d) Anode/hole injection layer/emitting layer/electron transport layer/cathode
e) Anode/hole injection layer/emitting layer/electron transport layer/electron injection layer/cathode
f) Anode/hole transport layer/emitting layer/cathode
g) Anode/hole transport layer/emitting layer/electron injection layer/cathode
h) Anode/hole transport layer/emitting layer/electron transport layer/cathode
i) Anode/hole transport layer/emitting layer/electron transport layer/electron injection layer/cathode
j) Anode/hole injection layer/hole transport layer/emitting layer/cathode
k) Anode/hole injection layer/hole transport layer/emitting layer/electron injection layer/cathode
l) Anode/hole injection layer/hole transport layer/emitting layer/electron transport layer/cathode
m) Anode/hole injection layer/hole transport layer/emitting layer/electron transport layer/electron injection layer/cathode
n) Anode/emitting layer/electron injection layer/cathode
o) Anode/emitting layer/electron transport layer/cathode
p) Anode/emitting layer/electron transport layer/electron injection layer/cathode
(where the symbol "/" indicates laminating the two layers sandwiching the symbol "/" one close to the other. Hereinafter the same.)
The organic EL device of the present embodiment may have two or more emitting layers. When, in any of the layer configurations of a) to p) above, a laminate sandwiched between the anode and the cathode is defined as "structural unit A", the configuration of an organic EL device having two emitting layers is exemplified by the layer configuration shown in q) below. However, the layer configurations of two structural units A may be the same or different.
q) Anode/(structural unit A)/charge generation layer/(structural unit A)/cathode
In addition, when "(structural unit A)/charge generation layer" is defined as "structural unit B," the configuration of an organic EL device having three or more emitting layers is exemplified by the layer configuration shown in r) below:
r) Anode/(structural unit B)x/(structural unit A)/cathode

where the symbol "x" represents an integer of 2 or more, and (structural unit B)x represents a laminate where structural unit B is laminated x times. However, the layer configurations of a plurality of (structural units B) may be the same or different.

Here, the charge generation layer refers to a layer that generates holes and electrons when an electric field is applied to it. Examples of the charge generation layer include a thin film made of a vanadium oxide, an indium tin oxide (ITO), a molybdenum oxide, or the like.

In the organic EL device, an insulating layer having a thickness of 2 nm or less may be provided adjacent to the electrode to improve the adhesion to the electrode and charge injection from the electrode as well. In addition, a thin buffer layer may be inserted into the interface between the layers that are adjacent to each other, to improve the adhesion of the interface and prevent mixing.

A specific configuration of each layer will be described below. However, the emitting layer 5 and the hole injection layer 7 were described earlier, so no duplicated description is given. In addition, the anode and/or the cathode can each use the first electrode or the second electrode described above, so no duplicated description is given.

<Hole transport layer>

Examples of a hole transport material constituting the hole transport layer include polyvinyl carbazole or a derivative thereof, polysilane or a derivative thereof, a polysiloxane derivative having an aromatic amine on a side chain or the main chain, a pyrazoline derivative, an arylamine derivative, a stilbene derivative, a triphenyldiamine derivative, polyaniline or a derivative thereof, polythiophene or a derivative thereof, polyarylamine or a derivative thereof, polypyrrole or a derivative thereof, poly(p-phenylenevinylene) or a derivative thereof, or poly(2,5-thienylenevinylene) or a derivative thereof.

Among these hole transport materials, as a hole transport material, a polymer hole transport material such as polyvinylcarbazole or a derivative thereof, polysilne or a derivative thereof, a polysiloxane derivative having an aromatic amine compound group on a side chain or the main chain, polyaniline or a derivative thereof, polythiophene or a derivative thereof, polyarylamine or a derivative thereof, poly(p-phenylenevinylene) or a derivative thereof, or poly(2,5-thienylenevinylene) or a derivative thereof is preferable, and polyvinylcarbazole or a derivative thereof, polysilne or a derivative thereof, a polysiloxane derivative having an aromatic amine on a side chain or the main chain, and the like are more preferable. For a low-molecular weight hole transport material, the material is preferably dispersed in a polymer binder for use.

Examples of a method of forming a film of a hole transport layer include, for a low-molecular weight hole transport material, a method of forming a film from a mixed solution of the low-molecular weight hole transport material and a polymer binder and, for a high-molecular weight hole transport material, a method of forming a film from a solution of the material.

The solvent used for forming a film from a solution needs only to dissolve a hole transport material, and examples of such a solvent include chlorine solvents such as chloroform, methylene chloride, and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate, and ethyl cellosolve acetate.

Examples of a method of forming a film from a solution include coating methods such as spin coating, casting, microgravure coating, gravure coating, bar coating, roll coating, wire bar coating, dip coating, spray coating, screen printing, flexographic printing, offset printing, and ink jet printing.

As the polymer binder to be mixed, a polymer binder that does not inhibit charge transport very much is preferable, and a polymer binder that does not absorb visible light much is preferably used. Examples of the polymer binder include polycarbonate, polyacrylate, polymethyl acrylate, polymethyl methacrylate, polystyrene, polyvinyl chloride, and polysiloxane.

The optimum film thickness of the hole transport layer varies depending on the material used and is selected so that drive voltage and luminous efficiency are reasonable as well as needs to be high enough at least to prevent the occurrence of a pin hole. A too high thickness causes a high device drive voltage and is thus not preferable. For this reason, the film thickness of the hole transport layer is for example 1 nm to 1 $\mu$m, preferably 2 nm to 500 nm, and more preferably 5 nm to 200 nm.

<Electron injection layer>

As an electron injection material constituting the electron injection layer, an alkali metal, an alkaline earth metal, or an alloy containing one or more of the metals or an oxide, a halide, and a carbonate of the metals, or a mixture of the substances, or the like is used depending on the type of the emitting layer. Examples of an alkali metal or an oxide, a halide, or a carbonate thereof include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of an alkaline earth metal or an oxide, a halide, or a carbonate thereof include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be a laminate where two or more layers are laminated. Examples of such a laminate include LiF/Ca. The electron injection layer is formed by evaporation, sputtering, printing, or the like. The film thickness of the electron injection layer is preferably about 1 nm to 1 $\mu$m.

<Electron transport layer>

Examples of an electron transport material constituting the electron transport layer include an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or a metal complex of 8-hydroxyquinoline or a derivative thereof, polyquinoline or a derivative thereof, polyquinoxaline or a derivative thereof, and polyfluorene or a derivative thereof.

Among these, as the electron transport material, an oxadiazole derivative, benzoquinone or a derivative thereof, anthraquinone or a derivative thereof, or a metal complex of 8-hydroxyquinoline or a derivative thereof, polyquinoline or a derivative thereof, polyquinoxaline or a derivative thereof, and polyfluorene or a derivative thereof are preferable, and 2-(4-biphenylyl)-5-(4-t-butylphenyl)-1,3,4-oxadiazole, benzoquinone, anthraquinone, tris(8-quinolinol)aluminum, and polyquinoline are more preferable.

The use of the organic EL device 8 of the embodiment allows the realization of a lighting device comprising an organic EL device, or a display device comprising a plurality of organic EL devices, or a surface light source used as a scanner light source or a backlight for display devices.

Examples of a display device comprising the organic EL device include a segment display device and a dot matrix display device. Examples of the dot matrix display device include an active matrix display device and a passive matrix display device. The organic EL device is used as a light-emitting device constituting each pixel in an active matrix display device and a passive matrix display device. In addition, the organic EL device is used as a light-emitting device constituting each segment or a backlight in a segment display device and as a backlight in a liquid crystal display device.

[Example]

[Example 1]

<Substrate preparation>

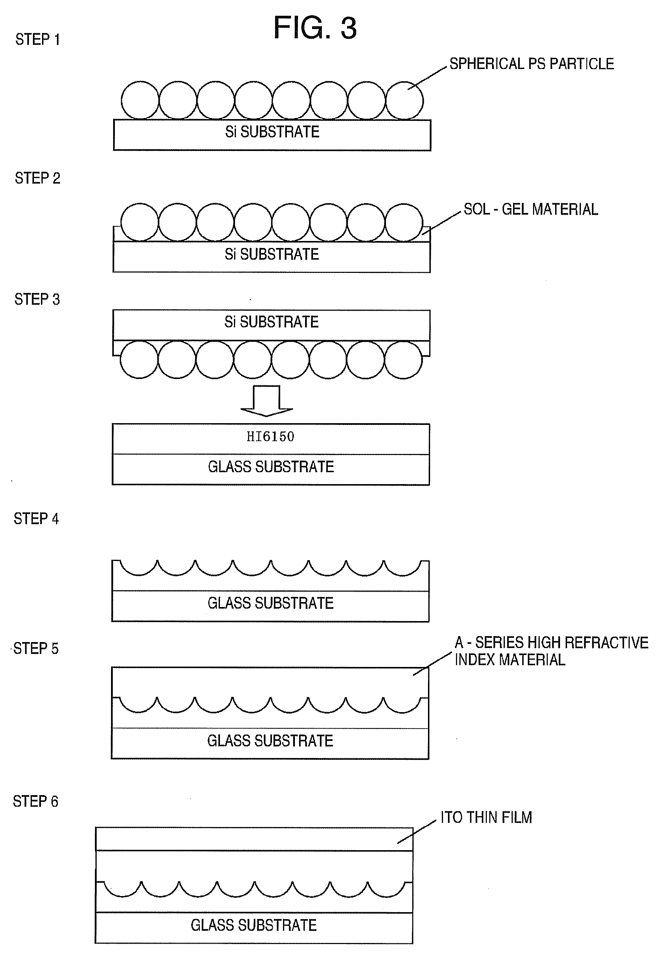

A process for producing a substrate with electrode is explained below with reference to Fig. 3.

Step 1: Monolayer of spherical polystyrene (PS) particles

The surface of a Si substrate was treated by $O_2$ plasma for 1 min, resulting in the surface to be hydrophilic. A monolayer of spherical PS particles with a mean diameter of 2 $\mu$m was self-assembled on the surface of the Si substrate from a colloidal suspension of spherical PS particles purchased from Duck Scientific Corporation. A simple method was used to deposit the spherical PS particles on the Si substrate in this Example. Several drops of the colloidal suspension of the spherical PS particles were put on the surface of the Si substrate and then spread to the desired region by tilting the Si substrate to about 40°. The concentration of the spherical PS particles in the colloidal suspension was adjusted to be around 20% by weight before the deposition of the suspension. Due to gravity effect, a uniform thin layer of the suspension containing the spherical PS particles was formed on the surface of the Si substrate. The solvent in the uniform thin layer was then evaporated. As the solvent was evaporated, the spherical PS particles were self-assembled into a monolayer of hexagonally close-packed colloidal crystal due to lateral capillary effect.

Step 2: Fixation of spherical PS particles

The interstices of the spherical PS particles were then filled with silica to fix the spherical PS particles to the Si substrate. First, a liquid sol-gel material (Silicafilm from Emulsitone Company, USA) was used for spin coating and then gelled. The sol-gel material was used in such an amount as to completely fill the interstices therewith but not to overfill so that the spherical PS particles were exposed to the surface. Thus, a mold was made.

Step 3: Imprinting

HI6150, a low refractive index material, purchased from Addison Clear Wave (USA) (n = 1.575 with a wavelength of 589 nm) was spin coated to a glass substrate (50% by weight in methy ethyl ketone) at 5000rpm for 30 sec and then softly baked at 70°C for 5 min. Imprinting was carried out using the mold made in the above step 2 at the following conditions (1) to (3):

(1) Temperature = 70°C, pressure = 40 bar for 90 sec
(2) Temperature = 70°C, pressure= 40 bar and UV exposure for 20 sec
(3) Demolding at 50°C.

Step 4: Removal of the particles

The spherical PS particles from the mold could be partially transferred to the glass substrate imprinted. Therefore, the transferred spherical PS particles were removed by sonicating the sample in toluene.

Step 5: Planarization of the layer

A titania-containing A-series high refractive index material, purchased from Brewer Science (USA) (n = 1.97 with a wavelength of 700 nm, n = 2.17 with a wavelength of 400 nm) was spin coated onto the imprinted layer of the low refractive index HI6150 to planarize the imprinted layer. The A-series high refractive index material required baking in order to be cured and remove the solvent. The spin coating with the A-series high refractive index material followed by baking was carried out seven times in this Example. The spin coating was carried out at 1500 rpm for 30 sec. The baking was each carried out on a hot-plate stepwise at 120°C for 30 min, 200°C for 15 min and then 350°C for 15 min.

Step 6: Formation of ITO thin film

ITO deposition was conducted on the layer of the A-series high refractive index material to form an ITO thin film (refractive index n = 2) in a sputtering apparatus manufactured by ULVAC under the following conditions: process pressure = 0.3 Pa, process temperature < 60°C, deposition rate: 4 nm/sec, ITO thickness 130 nm and sheet resistance = 25 ohm per square.

<Substrate evaluation>

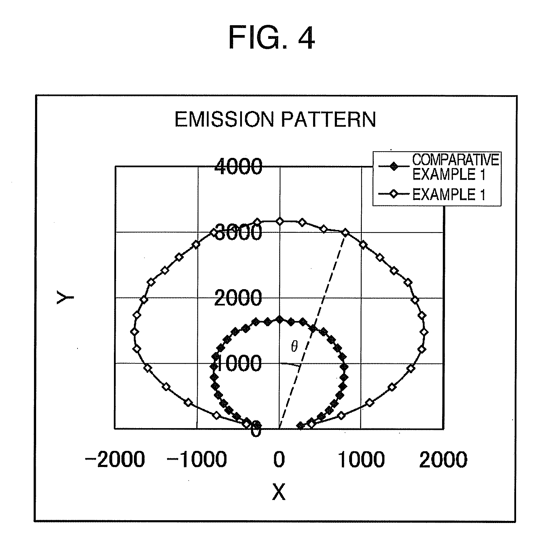

A green light-emitting polymer light-emitting material (trade name: Lumation GP1300, Sumation Co., Ltd.) was dissolved in toluene to prepare a coating solution having a polymer light-emitting material concentration of 1.2 mass %, and this coating solution was applied to the ITO thin film on the substrate obtained above by spin coating to form an emitting layer. The emitting layer obtained had a film thickness of 100 nm. When ultraviolet light having a wavelength of 254 nm entered the emitting layer side, the PL (Photoluminescence) emission intensity of the green light going out of the substrate side opposite to the emitting layer side was measured. The emission pattern of the PL emission intensity is shown in Fig. 4. Fig. 2 shows the PL emission intensity expressed as the distance from the origin o with (X, Y) = (0, 0). In addition, the emission angle θ is expressed as the angle θ formed between the line joining the origin o with a measurement point and the axial line where X = 0 (Y-axis passing through the origin) in Fig. 2. For example, the measurement at a measurement point where "θ = 0" represents the emission intensity of the PL emitted from the substrate surface.

[Comparative Example 1]

<Substrate preparation>

An ITO thin film was formed on a glass substrate having a smooth surface to produce a substrate with electrode in the same manner as in Example 1.

<Substrate evaluation>

As in Example 1, an emitting layer emitting green light was formed on the ITO thin film of the substrate obtained above by coating, and as in Example 1, its PL emission intensity was measured. The emission pattern of the PL emission intensity is shown in Fig. 4.

As shown in Fig. 4, the PL emission pattern of Comparative Example 1 is within the PL emission pattern of Example 1, and this indicates that the use of the substrate of Example 1 increases PL emission intensity in the whole emission angle. In addition, the measurement of the amount of PL emission extracted from the substrate surface with an integrating sphere indicates that the amount of PL emission of Example 1 is 2.6 with respect to the amount of PL emission of Comparative Example 1 set to "1." As mentioned above, preparation of an organic EL device on the substrate obtained in Example 1 increases light extraction efficiency.

[INDUSTRIAL APPLICABILITY]

According to the present invention, a substrate with electrode for an organic electroluminescent device comprising a structure that allows for a high light extraction efficiency can be easily prepared.

[REFERENCE SIGNS LIST]

| 1 | Substrate with electrode |
|---|---|
| 2 | Low-refractive index layer |
| 3 | Functional layer |
| 4 | First electrode |
| 5 | Emitting layer |
| 6 | Second electrode |
| 7 | Hole injection layer |
| 8 | Organic EL device |
| 11 | Mold |
| 12 | Particles |
| 13 | Frame |
| 14 | Base substrate |
| 15 | Adhesive member |

**Claims**

**1.** A process for producing a substrate with electrode comprising a low-refractive index layer, a functional layer, and a transparent electrode that are laminated in this order, the substrate being for an organic electroluminescent device wherein the refractive index n1 of the electrode, the refractive index n2 of the functional layer, and the refractive index n3 of the low-refractive index layer satisfy the following formula (1):

$$\begin{cases} 0.3 \geqq (n1 - n2) \geqq 0 \\ n1 \geqq n2 > n3 \end{cases} \quad \ldots (1)$$

the process comprising

the step of forming the low-refractive index layer by forming raised and depressed portions on the surface of the low-refractive index layer by means of imprinting that uses a mold wherein multiple particles having an average particle size of 1.0 $\mu$m to 200 $\mu$m are laid on the surface of the base substrate of the mold, the step of forming the functional layer by applying a coating solution containing a material that will become the functional layer onto the surface of the low-refractive index layer wherein the raised and depressed portions have been formed and curing the coating, and the step of forming the electrode on the functional layer.

2. The process according to claim 1 wherein the multiple particles are each approximately spherical and are laid on the surface of the base substrate in a nearly close-packed arrangement.

3. An organic electroluminescent device comprising a substrate with electrode prepared by the process according to claim 1 or 2.

4. Alighting device comprising an organic electroluminescent device according to claim 3.

5. A display device comprising a plurality of organic electroluminescent devices according to claim 3.

# FIG. 1

# FIG. 2

(1)

(2)

# FIG. 3

STEP 1

SPHERICAL PS PARTICLE

Si SUBSTRATE

STEP 2

SOL - GEL MATERIAL

Si SUBSTRATE

STEP 3

Si SUBSTRATE

HI6150

GLASS SUBSTRATE

STEP 4

GLASS SUBSTRATE

STEP 5

A - SERIES HIGH REFRACTIVE INDEX MATERIAL

GLASS SUBSTRATE

STEP 6

ITO THIN FILM

GLASS SUBSTRATE

# FIG. 4

## INTERNATIONAL SEARCH REPORT

| | International application No. |
|---|---|
| | PCT/JP2010/063646 |

**A. CLASSIFICATION OF SUBJECT MATTER**
*H05B33/02*(2006.01)i, *H01L51/50*(2006.01)i, *H05B33/10*(2006.01)i

According to International Patent Classification (IPC) or to both national classification and IPC

**B. FIELDS SEARCHED**

Minimum documentation searched (classification system followed by classification symbols)
H05B33/02, H01L51/50, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-296438 A (Mitsubishi Chemical Corp.), 21 October 2004 (21.10.2004), paragraphs [0092] to [0098], [0106], [0111], [0117], [0118] & US 2006/0049745 A1 & EP 1603367 A1 & WO 2004/089042 A1 & KR 10-2005-0111348 A | 1-5 |
| A | JP 2007-287486 A (International Test & Engineering Services Co., Ltd.), 01 November 2007 (01.11.2007), paragraphs [0033], [0034], [0048] & US 2007/254162 A1 & EP 1848050 A2 | 1-5 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>27 August, 2010 (27.08.10) | Date of mailing of the international search report<br>07 September, 2010 (07.09.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/063646

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-66027 A (Fuji Electric Holdings Co., Ltd.), 21 March 2008 (21.03.2008), paragraph [0056]; fig. 4 (Family: none) | 1-5 |
| A | JP 2005-322490 A (Nitto Denko Corp.), 17 November 2005 (17.11.2005), paragraphs [0030] to [0032]; fig. 1 (Family: none) | 1-5 |
| A | JP 2007-227355 A (Samsung Electronics Co., Ltd.), 06 September 2007 (06.09.2007), paragraph [0049] & US 2007/0138460 A1 & EP 1798783 A2 & KR 10-2007-0065080 A | 1-5 |
| P,A | WO 2009/119889 A1 (Sumitomo Chemical Co., Ltd.), 01 October 2009 (01.10.2009), entire text; all drawings & JP 2009-259805 A | 1-5 |

Form PCT/ISA/210 (continuation of second sheet) (July 2009)

**EP 2 469 977 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003086353 A